# EUROPEAN PATENT SPECIFICATION

(11) **EP 3 703 139 B1**
(45) Date of publication and mention of the grant of the patent: **04.12.2024**
(21) Application number: 18871713.6
(22) Date of filing: 24.10.2018
(51) Int. Cl.: H10N 10/82, H02N 11/00

(54) **THERMOELECTRIC MODULE**
THERMOELEKTRISCHES MODUL
MODULE THERMOÉLECTRIQUE

(30) Priority: 25.10.2017 JP 2017206262
(43) Date of publication of application: 02.09.2020
(73) Proprietor: KYOCERA Corporation, Kyoto 612-8501 (JP)
(72) Inventor: FURUKAWA,Tomohiro, Kyoto-shi Kyoto 612-8501 (JP)
(74) Representative: Viering, Jentschura & Partner mbB Patent- und Rechtsanwälte
(86) International application number: PCT/JP2018/039497
(87) International publication number: WO 2019/082928

(56) References cited:
- JP-A- 2003 197 982
- JP-A- 2008 244 239
- JP-A- 2016 171 230
- No further relevant documents disclosed

## Description

### Technical Field

The present disclosure relates to a thermoelectric module, and more particularly, to a thermoelectric module used for temperature control in an automotive seat cooler or a fuel cell, in particular.

### Background Art

For example, a thermoelectric module undergoes a difference in temperature between one principal surface and the other principal surface with the supply of electric power to thermoelectric elements. Moreover, for example, a thermoelectric module produces electric power via thermoelectric elements upon a difference in temperature between one principal surface of the module and the other principal surface. Thermoelectric modules having such useful characteristics are used for temperature control purposes or thermoelectric power generation purposes, for example.

An example of such thermoelectric modules includes: a pair of support substrates including mutually opposed regions; wiring conductors disposed on opposed one principal surfaces of the pair of support substrate, respectively; a plurality of thermoelectric elements disposed between the one principal surfaces of the pair of support substrates; and a lead member joined to the wiring conductor located on one support substrate of the pair of support substrates.

### Citation List

### Patent Literature

Patent Literature 1: Japanese Unexamined Patent Publication JP-A 2008-244239
Moreover, JP 2016-171230 A discloses a thermoelectric generation module comprising a plurality of thermoelectric elements, a pair of flexible boards holding the thermoelectric elements therebetween, a plurality of interelement electrodes, a lead wire, and a reinforcing pattern interposed between the flexible boards.

### Summary of Invention

The present invention provides a thermoelectric module according to claim 1. Preferred embodiments are described in the dependent claims.

### Brief Description of Drawings

FIG. 1 is a schematic perspective view showing an example of the thermoelectric module;
FIG. 2 is a plan view of the thermoelectric module shown in FIG. 1;
FIG. 3 is a partially transparent side view of the thermoelectric module shown in FIG. 2;
FIG. 4 is a schematic sectional view of the thermoelectric module taken along the line IV-IV in FIG. 2;
FIG. 5 is a sectional view of a main part of the thermoelectric module taken along the line V-V in FIG. 4;
FIG. 6 is a sectional view of a main part of the thermoelectric module taken along the line VI-VI in FIG. 4;
FIG. 7 is a schematic sectional view showing another example of the thermoelectric module;
FIG. 8 is a schematic sectional view showing still another example of the thermoelectric module; and
FIG. 9 is a schematic sectional view showing still another example of the thermoelectric module.

### Description of Embodiments

In a conventional thermoelectric module with a lead member soldered to a wiring conductor located on a low-temperature-side support substrate of the pair of support substrates which has a relatively low temperature, the lead member is positioned in parallel with the principal surface of the support substrate.

In the thermoelectric module so constructed, transmission of heat from the lead member to the wiring conductor and the support substrate leads to poor cooling performance, and, the lead member may become detached from the wiring conductor under external forces, for example.

The disclosure addresses the problems discussed above, and aims to provide a thermoelectric module that achieves reduction in cooling performance degradation, and reduction in separation of a lead member from a wiring conductor.

A thermoelectric module in accordance with an embodiment of the invention will now be described with reference to drawings.

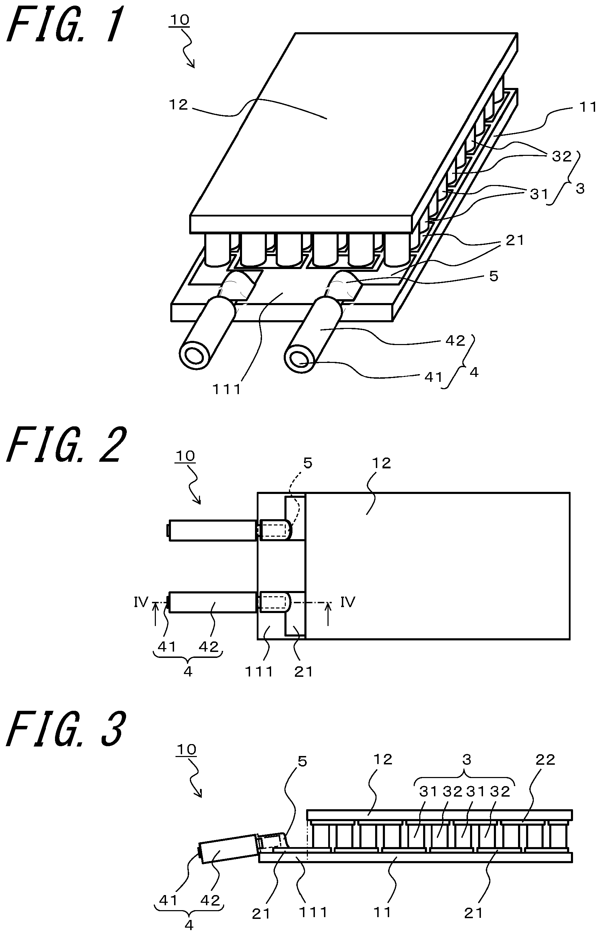

A thermoelectric module 10 shown in FIGS. 1 to 4 includes: a pair of support substrates 11 and 12 including mutually opposed regions; wiring conductors 21 and 22 disposed on opposed one principal surfaces of the support substrates 11 and 12, respectively; a plurality of thermoelectric elements 31 and 32 disposed between the one principal surfaces of the support substrates 11 and 12; a lead member 4 joined to the wiring conductor 21 located on one support substrate 11 of the pair of support substrates; and an electrically conductive joining material 5 for joining the wiring conductor 21 and the lead member 4 together.

The pair of support substrates 11 and 12 constituting the thermoelectric module 10 include mutually opposed regions of, for example, a rectangular shape, for holding and supporting the plurality of thermoelectric elements 3 therebetween in sandwich style. For example, dimensions of each of the mutually opposed rectangular regions can be set to 40 to 80 mm in longitudinal length, 20 to 40 mm in transverse length, and 0.25 to 0.35 mm in thickness in plan configuration.

An upper surface of the support substrate 11 is placed so as to serve as one principal surface facing the support substrate 12, and, a lower surface of the support substrate 12 is placed so as to serve as one principal surface facing the support substrate 11. For example, the support substrate 11 serves as a low-temperature-side support substrate which has a relatively low temperature, whereas the support substrate 12 serves as a high-temperature-side support substrate which has a relatively high temperature.

The support substrate 11 bears the wiring conductor 21 on its upper surface serving as one principal surface facing the support substrate 12, and, the support substrate 12 bears the wiring conductor 22 on its lower surface serving as one principal surface facing the support substrate 11. Thus, the upper-surface side of the support substrate 11 and the lower-surface side of the support substrate 12 are each made of an insulating material. For example, the pair of support substrates 11 and 12 are each constructed of a 50 to 200 µm-thick substrate body made of alumina filler-added epoxy resin, with a 50 to 500 um-thick copper sheet bonded to the outward principal surface of the substrate body. Alternatively, the pair of support substrates 11 and 12 may each be constructed of a substrate body made of a ceramic material such as alumina or aluminum nitride, with a metal sheet such as a copper sheet bonded to the outward principal surface of the substrate body. In another alternative, each support substrate may be constructed of a substrate body made of a conductive material such as copper, silver, or a silver-palladium material, with an insulating layer made of, for example, epoxy resin, polyimide resin, alumina, or aluminum nitride formed on the inward principal surface of the substrate body.

The wiring conductors 21 and 22 are disposed on the opposed inward one principal surfaces of the support substrates 11 and 12, respectively. For example, the wiring conductors 21 and 22 are obtained by laminating a copper sheet to each of the opposed inward principal surfaces of the support substrates 11 and 12, with a mask placed on each of a part of the copper sheet which constitutes the wiring conductor 21 and a part of the copper sheet which constitutes the wiring conductor 22, and removing mask-free areas of each copper sheet by etching. Alternatively, it is possible to use copper sheets die-cut in the form of the wiring conductors 21 and 22. The material of construction of the wiring conductors 21 and 22 is not limited to copper. For example, silver or a silver-palladium material may be used instead.

Between the opposed inward one principal surfaces of the support substrates 11 and 12, there are provided the plurality of thermoelectric elements 3 electrically connected to one another via the wiring conductors 21 and 22. The plurality of thermoelectric elements 3 include p-type thermoelectric elements 31 and n-type thermoelectric elements 32. The thermoelectric elements 3 are members for temperature control utilizing the Peltier effect, or members for power generation utilizing the Seebeck effect. For example, the plurality of thermoelectric elements 3 are arranged in a matrix of rows and columns with spacing which equals 0.5 to 2 times the diameter of each thermoelectric element 3. The thermoelectric elements 3 are soldered to the wiring conductors 21 and 22. More specifically, the p-type thermoelectric elements 31 and the n-type thermoelectric elements 32 are alternately disposed adjacent each other, while being electrically connected in series via the wiring conductors 21 and 22 and solder. That is, all the thermoelectric elements 3 are connected in series.

The body of each of the plurality of thermoelectric elements 3 is formed of a thermoelectric material made of A₂B₃ crystal (A refers to Bi and/or Sb, and B refers to Te and/or Se), or preferably formed of a Bi (bismuth) and Te (tellurium)-based thermoelectric material. More specifically, the p-type thermoelectric element 31 is formed of, for example, a thermoelectric material made of a solid solution of Bi₂Te₃ (bismuth telluride) and Sb₂Te₃ (antimony telluride). On the other hand, the n-type thermoelectric element 32 is formed of, for example, a thermoelectric material made of a solid solution of Bi₂Te₃ (bismuth telluride) and Bi₂Se₃ (bismuth selenide).

For example, the thermoelectric element 3 may be shaped in a circular cylinder or a polygonal prism such as a quadrangular prism. The thermoelectric element 3 of circular cylinder shape, in particular, is less influenced by thermal stress caused therein under heat cycles during use. For example, dimensions of the circular cylinder-shaped thermoelectric element 3 are set to 0.5 to 3 mm in diameter and 0.3 to 5 mm in height.

For example, the thermoelectric material constituting the p-type thermoelectric element 31 is formed as a rod-like body having a circular sectional profile of 0.5 to 3 mm in diameter from a p-type thermoelectric material made of Bi, Sb, and Te, which has undergone one melting-and-solidification process, through unidirectional solidification using Bridgman method. Moreover, the thermoelectric material constituting the n-type thermoelectric element 32 is formed as a rod-like body having a circular sectional profile of 0.5 to 3 mm in diameter from an n-type thermoelectric material made of Bi, Te, and Se, which has undergone one melting-and-solidification process, through unidirectional solidification using Bridgman method.

After being coated on its side surface with a resist to prevent adhesion of plating as required, each thermoelectric material is cut in a length (thickness) of, for example, 0.3 to 5 mm with a wire saw. Subsequently, on an as needed basis, a Ni layer is formed only on the cut surface of the material by electrolytic plating, for example, and then a Sn layer is formed on the Ni layer. Thus, the p-type thermoelectric elements 31 and the n-type thermoelectric elements 32 are obtained.

A sealing material made of, for example, resin such as silicone resin or epoxy resin may be provided as required around the plurality of thermoelectric elements 3 disposed between the support substrate 11 and the support substrate 12. Although the outer periphery of the construction becomes deformed greatly due to a difference in temperature between the pair of support substrates 11 and 12, the sealing material for filling the gaps among a plurality of outer periphery-side thermoelectric elements 3 disposed between the one principal surface of the support substrate 11 and the one principal surface of the support substrate 12 serves as a reinforcing material, thereby restraining the thermoelectric elements 3 from separating from the wiring conductors 21 and 22.

One support substrate 11 of the pair of support substrates 11 and 12 is provided with an extended portion 111 as required. The extended portion 111 is a part of the support substrate 11 which lies outside the part thereof opposed to the support substrate 12 as seen in a plan view, or equivalently, a part of the support substrate 11 which lies to the left of the chain double-dashed line in FIG. 3.

For example, extending amount (extending length) of the extended portion 111 are set to 1 to 5 mm, and a width along the entire length of a short side of the support substrate 11 is set to 5 to 40 mm.

The wiring conductor 21 disposed on the one principal surface of the support substrate 11 lies also on the extended portion 111, and an end of the lead member 4 is joined, with the electrically conductive joining material 5 such as solder, to the wiring conductor 21 disposed on one principal surface of the extended portion 111. The wiring conductor 21 and the lead member 4 may be joined together by laser beam welding rather than soldering.

The lead member 4 is intended for electrical connection between the thermoelectric module 10 and an external circuit, and provides electric power to the thermoelectric element 3 or extracts electric power produced by the thermoelectric element 3. The lead member 4 includes a core 41 and a covering layer 42. The front end of the lead member 4, which is joined to the wiring conductor 21, is made as a bared portion of the core 41. Moreover, the lead member 4 includes the covering layer 42 with which the core 41 is covered on the side located close to the rear end of the lead member 4 rather than on the side located close to the front end thereof. Expressed differently, the covering layer 42 is disposed about the periphery of the core 41, except at least for the front end of the core 41 which is electrically connected to the wiring conductor 21.

The front end of the lead member 4 refers to an end of the lead member 4 which is joined to the wiring conductor 21 located on the support substrate 11. The front end of the lead member 4 in the form of the bared portion of the core 41 refers to a part of the core 41 which extends beyond an edge of the covering layer 42 located close to the front end for electrical connection of the lead member 4 to the wiring conductor 21. For connection between the lead member 4 and an external circuit, the rear end of the lead member 4 may also be made as a bared portion of the core 41, or the rear end of the lead member 4 may be provided with a connector.

For example, the core 41 is formed of a bundle of a plurality of metallic wires such as copper wires, for example, a bundle of 15 to 30 copper wires, each having a diameter of 0.15 to 0.30 mm. For example, the covering layer 42 is formed of a 0.2 to 0.4 mm-thick sheet made of polyvinyl chloride or polyethylene.

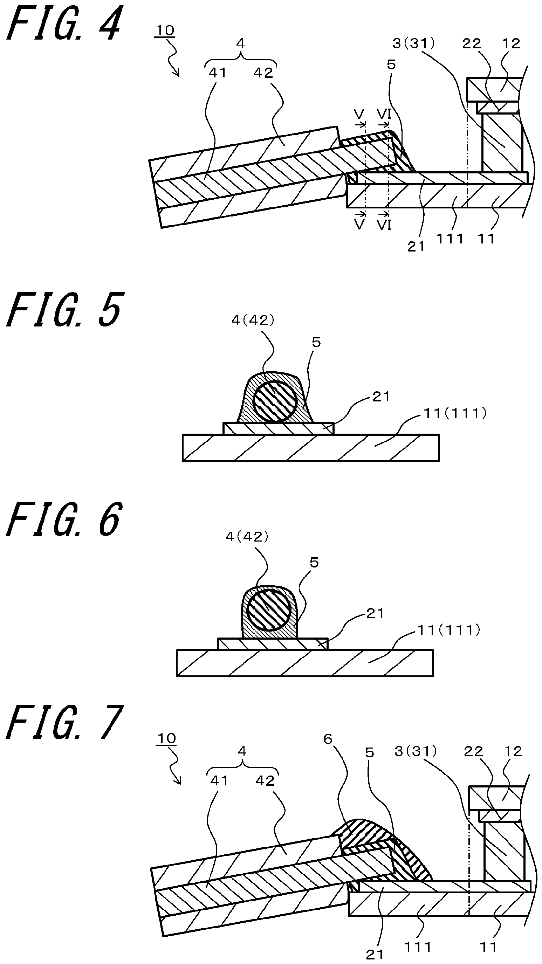

As shown in FIGS. 5 and 6, the bonding interface between the electrically conductive joining material 5 and the wiring conductor 21 is smaller in width on the side of the bonding interface which is close to the thermoelectric element 3 than on the side of the bonding interface which is away from the thermoelectric element 3, as viewed in a section in a direction perpendicular to an axial direction of the lead member 4. This reduces the contact area on the side close to the thermoelectric element 3 where wide temperature variations are encountered. Thus, for the support substrate 11 serving as a low-temperature-side support substrate which has a relatively low temperature, transmission of heat from the lead member 4 to the wiring conductor 21 is reduced, and consequently the thermoelectric module 10 delivers a higher level of cooling performance. Moreover, the contact area is large on the side away from the thermoelectric element 3 enough to restrain the lead member 4 from separating from the wiring conductor 21, and consequently the thermoelectric module 10 becomes more durable against external force.

Let it be assumed that a junction between the electrically conductive joining material 5 and the wiring conductor 21 is divided lengthwise into two portions, namely a portion located farther away from the thermoelectric element 3 than the lengthwise midpoint of the junction, and a portion located nearer to the thermoelectric element 3 than the lengthwise midpoint of the junction. When viewed in a section in a width direction perpendicular to the length direction of the lead member 4, given that the width of the junction on the side close to the thermoelectric element 3 is 0.5 to 1.0 mm, then the junction on the side away from the thermoelectric element 3 has a width two to three times the width of the junction on the side close to the thermoelectric element 3.

As shown in FIGS. 3 and 4, in the thermoelectric module 10, the lead member 4 is inclined relative to a direction parallel to the one principal surface, as viewed in a section in a direction perpendicular to the one principal surface of the support substrate 11, as well as along the axial direction of the lead member 4. This reduces clearance between the support substrate 11 and the lead member 4, and thus can reduce ingress of moisture into the wiring conductor 21. Moreover, for the support substrate 11 serving as a high-temperature-side support substrate which has a relatively high temperature, on the occurrence of downwardly-curved convex warpage in the module which is in operation as a product due to the thermal expansion of the support substrate 11 and the thermal shrinkage of the support substrate 12, the lead member 4 takes a nearly horizontal position within a housing case accommodating the thermoelectric module 10. Thus, the module becomes more durable during the passage of current therethrough.

For example, the angle of inclination of the lead member 4 with respect to the one principal surface of the support substrate 11 falls in the range of 1 degree to 30 degrees.

Moreover, as shown in FIG. 7, a resin material 6 may be provided to cover the electrically conductive joining material 5 and at least part of the core 41. This achieves greater mechanical strength with which the support substrate 11 becomes resistant to deformation under the application of external force to the lead member 4. Thus, the lead member 4 can be restrained from separating from the wiring conductor 21, and consequently the thermoelectric module 10 becomes more durable against external force.

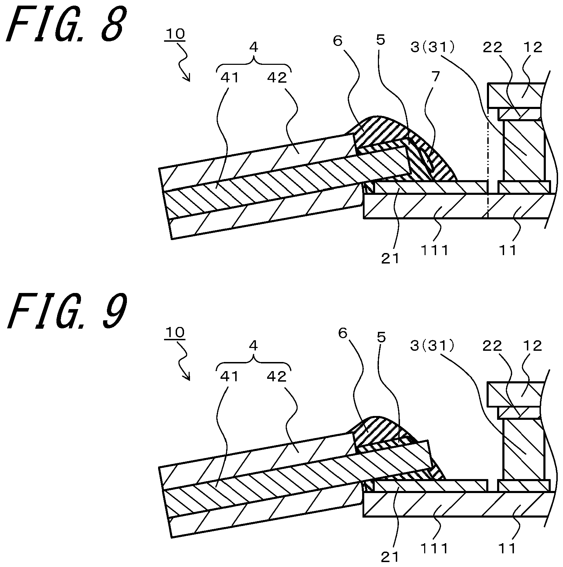

Moreover, as shown in FIG. 8, a void 7 may be provided in a part of the boundary of the electrically conductive joining material 5 and the resin material 6. This reduces distortion resulting from a difference in thermal expansion between the electrically conductive joining material 5 and the resin material 6, and thus can restrain the resin material 6 from separating from the electrically conductive joining material 5.

Moreover, as shown in FIG. 9, the core 41 may be configured to extend through and beyond the electrically conductive joining material 5, so that the front end of the core 41 is bare of the electrically conductive joining material 5. This increases the surface area of the joined portion of the lead member 4, and thus achieves greater heat-dissipating capability with which Joule heat generated in the joined portion can be dissipated efficiently. Dissipation of heat from the lead member 4 can minimize cooling performance degradation.

### Examples

The following describes examples.

As the first step, p-type and n-type thermoelectric materials made of Bi, Sb, Te, and Se were melted and solidified by Bridgman method to prepare rod-like materials each having a circular sectional profile of 1.5 mm in diameter. More specifically, the p-type thermoelectric material was formed from a solid solution of Bi₂Te₃ (bismuth telluride) and Sb₂Te₃ (antimony telluride), and the n-type thermoelectric material was formed from a solid solution of Bi₂Te₃ (bismuth telluride) and Bi₂Se₃ (bismuth selenide). The surfaces of the p-type thermoelectric material and the n-type thermoelectric material each in rod-like form were roughened by etching using nitric acid.

Next, the rod-like p-type thermoelectric material and the rod-like n-type thermoelectric material were cut into 1.6 mm in height, or 1.6 mm in thickness with a wire saw to obtain a p-type thermoelectric element and an n-type thermoelectric element. A nickel layer was formed on each of the cut surfaces of the obtained p-type thermoelectric element and n-type thermoelectric element by electrolytic plating.

Next, a substrate clad on both principal surfaces with copper, which is prepared by bonding a 105 um-thick copper sheet to both sides of alumina filler-added epoxy resin under pressure, was printed with a solder paste by screen printing.

On the solder paste, 127 p-type thermoelectric elements and 127 n-type thermoelectric elements were arranged electrically in series with a mounter. The arrangement of the p-type thermoelectric elements and the n-type thermoelectric elements was sandwiched between a pair of support substrates. The construction so obtained was heated in a reflow furnace, with its upper and lower surfaces subjected to pressure, and, the thermoelectric elements were soldered to corresponding wiring conductors.

Next, a silicone-made sealing material was applied to between the pair of support substrates with an air dispenser.

To permit the passage of electric current through the obtained thermoelectric module, two lead members were joined to the construction with a solder-made conductive joining material. At this time, samples in which, by carrying out adjustments of the amount of solder supply and the angle at which the lead member was joined, the area of contact between the conductive joining material and the wiring conductor (a width of a bonding interface between the conductive joining material and the wiring conductor) was adjusted, as shown in FIGS. 4 to 6, were prepared (Sample No. 1 and Sample No. 2). Table 1 shows a list of bonding interface widths as viewed in a section in the width direction of the lead member.

Moreover, samples in which, by applying thermosetting epoxy resin so as to cover the joined portion of the lead member (an electrically conductive joining material), with an air dispenser, and thereafter curing the epoxy resin under heat in a dryer, the electrically conductive joining material and at least part of the core were covered with the resin material, as shown in FIG. 7, were prepared (Sample No. 3 to Sample No. 5). At this time, samples in which a void was provided in the boundary of solder and epoxy resin, as shown in FIG. 8, were prepared (Sample No. 4 and Sample No. 5).

In addition, sample in which a core length of a lead member was changed and the core of the lead member extended beyond the surface of the joined portion (the electrically conductive joining material) to provide a bared core portion, as shown in FIG. 9, was prepared (Sample No. 5).

Each sample was manufactured by 20 pieces (n = 20), and measurement results described later were an average of values of 20 pieces.

For each of the samples thus prepared, a horizontal force was applied to the lead member using a tensile strength tester, and the strength (before the endurance test) when the lead member was separated was measured. Table 1 shows the results.

Next, a thermal conductive grease was applied to a surface of the pair of support substrates of the obtained thermoelectric module, the thermoelectric module was set on a heat sink whose temperature was controlled at 75°C, and 60 W of power was supplied to the thermoelectric module to generate a temperature difference. A temperature difference at the maximum voltage was defined as the cooling performance. Thereafter, an endurance test in which the energization direction was reversed every 30 seconds was carried out for 10000 cycles.

Then, for the samples after the endurance test, a horizontal force was applied to the lead member using the tensile strength tester, the strength when the lead member was separated was measured, and a change rate of the lead member tensile strength before and after the endurance test was calculated. Table 1 shows the results.

**Table 1**

| Sample No. | Length of electrically conductive joining material-wiring conductor interface | | Resin material | Void | Bared core portion | Average of cooling performance level (°C) | Average of lead member tensile strength (N) | | Average of change rate |
|---|---|---|---|---|---|---|---|---|---|
| | Length on side close to thermoelectric elements (mm) | Length on side away from thermoelectric elements (mm) | | | | | Before endurance test | After endurance test | |
| 1 | 3.2 | 3.4 | Not provided | Not formed | Not provided | 63.6 | 114 | 93 | 18.4% |
| 2 | 1.5 | 3.6 | Not provided | Not formed | Not provided | 66.4 | 117 | 100 | 14.5% |
| 3 | 1.6 | 3.8 | Provided | Not formed | Not provided | 66.3 | 121 | 108 | 10.7% |
| 4 | 1.6 | 3.7 | Provided | Formed | Not provided | 66.5 | 118 | 111 | 5.9% |
| 5 | 1.5 | 3.5 | Provided | Formed | Provided | 66.7 | 114 | 112 | 1.8% |

As seen from Table 1, Sample No. 2 in which the area of contact between the electrically conductive joining material and the wiring conductor (the width of the bonding interface) is smaller on the side close to the thermoelectric elements than on the side away from the thermoelectric elements, is higher in cooling performance level and smaller in the change rate in lead member tensile strength than Sample No. 1 in which the area of contact on the side close to the thermoelectric elements is substantially equal to the area of contact on the side away from the thermoelectric elements.

Sample No. 3 in which the joined portion of the lead member is coated with the resin material is smaller in the change rate in lead member tensile strength and is thus more satisfactory than Sample No. 2.

Sample No. 4 in which the void is provided in the boundary of solder and epoxy resin is smaller in the change rate in lead member tensile strength and is thus more satisfactory than Sample No. 3.

Sample No. 5 in which the bared core portion extends beyond the surface of the joined portion (the electrically conductive joining material) is smaller in the change rate in lead member tensile strength and is thus more satisfactory than Sample No. 4.

### Reference Signs List

10: Thermoelectric module
11, 12: Support substrate
111: Extended portion
21, 22: Wiring conductor
3: Thermoelectric element
31: p-type thermoelectric element
32: n-type thermoelectric element
4: Lead member
41: Core
42: Covering layer
5: Electrically conductive joining material
6: Resin material
7: Void

## Claims

1. A thermoelectric module (10), comprising:
a pair of support substrates (11,12) comprising mutually opposed regions;
wiring conductors (21,22) disposed on one principal surface of one support substrate of the pair of support substrates (11,12) and one principal surface of another support substrate of the pair of support substrates (11,12), respectively, the one principal surface of the one support substrate (11) and the one principal surface of the other support substrate (12) being opposed to each other;
a plurality of thermoelectric elements (3) disposed between the one principal surface of the one support substrate (11) of the pair of support substrates (11,12) and the one principal surface of the other support substrate (12) of the pair of support substrates (11,12);
a lead member (4) joined to one wiring conductor of the wiring conductors (21,22), the one wiring conductor located on either the one support substrate (11) or the other support substrate (12) of the pair of support substrates (11,12), the lead member (4) comprising a core (41), and a covering layer (42) which covers a rear end-side part of the core (41), and which does not cover a front end-side part of the core (41); and
an electrically conductive joining material (5) which joins the one wiring conductor (21) and the lead member together (4),
wherein a bonding interface between the electrically conductive joining material (5) and the one wiring conductor (21) is smaller in width on a side of the bonding interface which is close to the thermoelectric elements (3) than on a side of the bonding interface which is away from the thermoelectric elements (3), as viewed in a respective section in a direction perpendicular to an axial direction of the lead member (4), and
wherein the lead member (4) is inclined relative to a direction parallel to the pair of support substrates (11,12), so that a front end of the lead member (4) is directed away from the one wiring conductor (21) in a direction from the rear end-side part of the core (41) to the front end-side part of the core (41), as viewed in a section of the thermoelectric module perpendicular to the pair of support substrates (11,12) and along the axial direction of the lead member (4).

2. The thermoelectric module (10) according to claim 1,
wherein the electrically conductive joining material (5) and at least part of the core (41) are covered with a resin material (6).

3. The thermoelectric module (10) according to claim 2,
wherein a void (7) is provided in a part of a boundary of the electrically conductive joining material (5) and the resin material (6).

4. The thermoelectric module (10) according to claim 1,
wherein the core (41) extends through and beyond the electrically conductive joining material (5), and a front end of the core (41) is bare of the electrically conductive joining material (5).

## Patentansprüche

1. Thermoelektrisches Modul (10), aufweisend:
ein Paar von Trägersubstraten (11, 12), die einander gegenüberliegende Bereiche aufweisen,
Verdrahtungsleiter (21, 22), die auf einer Hauptfläche eines Trägersubstrats des Paars von Trägersubstraten (11, 12) bzw. einer Hauptfläche eines anderen Trägersubstrats des Paars von Trägersubstraten (11, 12) angeordnet sind, wobei die eine Hauptfläche des einen Trägersubstrats (11) und die eine Hauptfläche des anderen Trägersubstrats (12) einander gegenüberliegen,
eine Mehrzahl von thermoelektrischen Elementen (3), die zwischen der einen Hauptfläche des einen Trägersubstrats (11) des Paars von Trägersubstraten (11, 12) und der einen Hauptfläche des anderen Trägersubstrats (12) des Paars von Trägersubstraten (11, 12) angeordnet sind,
ein Leitungselement (4), das mit einem Verdrahtungsleiter der Verdrahtungsleiter (21, 22) verbunden ist, wobei der eine Verdrahtungsleiter entweder auf dem einen Trägersubstrat (11) oder dem anderen Trägersubstrat (12) des Paars von Trägersubstraten (11, 12) angeordnet ist, wobei das Leitungselement (4) einen Kern (41) und eine Deckschicht (42) aufweist, die einen hinteren Endseitenteil des Kerns (41) bedeckt, und die einen vorderen Endseitenteil des Kerns (41) nicht bedeckt, und
ein elektrisch leitfähiges Verbindungsmaterial (5), das den einen Verdrahtungsleiter (21) und das Leitungselement (4) miteinander verbindet,
wobei eine Verbindungsgrenzfläche zwischen dem elektrisch leitfähigen Verbindungsmaterial (5) und dem einen Verdrahtungsleiter (21) auf einer Seite der
Verbindungsgrenzfläche, die nahe bei den thermoelektrischen Elementen (3) ist, eine geringere Breite als auf einer Seite der Verbindungsgrenzfläche hat, die von den thermoelektrischen Elementen (3) entfernt ist, bei Betrachtung in einem jeweiligen Schnitt in einer Richtung senkrecht zu einer Axialrichtung des Leitungselements (4), und
wobei das Leitungselement (4) relativ zu einer Richtung geneigt ist, die parallel zu dem Paar von Trägersubstraten (11, 12) ist, so dass ein vorderes Ende des Leitungselements (4) von dem einen Verdrahtungsleiter (21) weg gerichtet ist, in einer Richtung von dem hinteren Endseitenteil des Kerns (41) zu dem vorderen Endseitenteil des Kerns (41), betrachtet in einem Schnitt des thermoelektrischen Moduls senkrecht zu dem Paar von Trägersubstraten (11, 12) und entlang der Axialrichtung des Leitungselements (4).

2. Thermoelektrisches Modul (10) gemäß Anspruch 1,
wobei das elektrisch leitfähige Verbindungsmaterial (5) und mindestens ein Teil des Kerns (41) mit einem Harzmaterial (6) bedeckt sind.

3. Thermoelektrisches Modul (10) gemäß Anspruch 2,
wobei eine Lücke (7) in einem Teil einer Grenze des elektrisch leitfähigen Verbindungsmaterials (5) und des Harzmaterials (6) vorgesehen ist.

4. Thermoelektrisches Modul (10) gemäß Anspruch 1,
wobei sich der Kern (41) durch das elektrisch leitfähige Verbindungsmaterial (5) hindurch und darüber hinaus erstreckt und ein vorderes Ende des Kerns (41) frei von dem elektrisch leitfähigen Verbindungsmaterial (5) ist.

## Revendications

1. Module thermoélectrique (10), comprenant :
une paire de substrats de support (11, 12) comprenant des régions mutuellement opposées ;
des conducteurs de câblage (21, 22) disposés sur une surface principale d'un substrat de support de la paire de substrats de support (11, 12) et une surface principale d'un autre substrat de support de la paire de substrats de support (11, 12), respectivement, ladite une surface principale dudit un substrat de support (11) et ladite une surface principale dudit autre substrat de support (12) étant opposées l'une à l'autre ;
une pluralité d'éléments thermoélectriques (3) disposés entre ladite une surface principale dudit un substrat de support (11) de la paire de substrats de support (11, 12) et ladite une surface principale dudit autre substrat de support (12) de la paire de substrats de support (11, 12) ;
un élément de conduction (4) relié à un conducteur de câblage des conducteurs de câblage (21, 22), ledit un conducteur de câblage étant situé soit sur ledit un substrat de support (11), soit sur l'autre substrat de support (12) de la paire de substrats de support (11, 12), l'élément de conduction (4) comprenant un noyau (41) et une couche de recouvrement (42) qui recouvre une partie arrière de côté d'extrémité du noyau (41) et qui ne recouvre pas une partie avant de côté d'extrémité du noyau (41) ; et
un matériau de jonction électriquement conducteur (5) qui relie ledit un conducteur de câblage (21) et l'élément de conduction (4),
dans lequel une interface de liaison entre le matériau de jonction électriquement conducteur (5) et ledit un conducteur de câblage (21) est plus petite en largeur sur un côté de l'interface de liaison qui est proche des éléments thermoélectriques (3) que sur un côté de l'interface de liaison qui est éloigné des éléments thermoélectriques (3), selon une vue dans une section respective dans une direction perpendiculaire à une direction axiale de l'élément de conduction (4), et
dans lequel l'élément de conduction (4) est incliné par rapport à une direction parallèle à la paire de substrats de support (11, 12), de sorte qu'une extrémité avant de l'élément de conduction (4) est dirigée à l'écart dudit un conducteur de câblage (21) dans une direction allant de la partie arrière de côté d'extrémité du noyau (41) à la partie avant de côté d'extrémité du noyau (41), selon une vue dans une section du module thermoélectrique perpendiculaire à la paire de substrats de support (11, 12) et le long de la direction axiale de l'élément de conduction (4).

2. Module thermoélectrique (10) selon la revendication 1,
dans lequel le matériau de jonction électriquement conducteur (5) et au moins une partie du noyau (41) sont recouverts d'un matériau en résine (6).

3. Module thermoélectrique (10) selon la revendication 2,
dans lequel un vide (7) est prévu dans une partie d'une limite du matériau de jonction électriquement conducteur (5) et du matériau en résine (6).

4. Module thermoélectrique (10) selon la revendication 1,
dans lequel le noyau (41) s'étend à travers et au-delà du matériau de jonction électriquement conducteur (5), et une extrémité avant du noyau (41) est sans le matériau de jonction électriquement conducteur (5).
